Europäisches Patentamt

**European Patent Office**

**Office européen des brevets**

(11) Numéro de publication:

**0 027 405**
**A1**

## DEMANDE DE BREVET EUROPEEN

(21) Numéro de dépôt: **80401407.4**

(22) Date de dépôt: **03.10.80**

(51) Int. Cl.³: **G 05 F 1/66**

(30) Priorité: **10.10.79 FR 7925212**

(43) Date de publication de la demande:
**22.04.81 Bulletin 81/16**

(84) Etats Contractants Désignés:
**DE GB IT NL**

(71) Demandeur: **COMMISSARIAT A L'ENERGIE ATOMIQUE Etablissement de Caractère Scientifique Technique et Industriel**
**B.P. 510**
**F-75752 Paris Cedex 15(FR)**

(72) Inventeur: **Forrat, Francis**
**23 Boulevard Leclerc**
**F-38000 Grenoble(FR)**

(74) Mandataire: **Mongredien, André et al,**
**c/o Brevatome 25, rue de Ponthieu**
**F-75008 Paris(FR)**

(54) Dispositif de pilotage, à la puissance maximale d'un convertisseur photovoltaique.

(57) L'invention concerne un dispositif (1) de pilotage, à la puissance maximale, d'un convertisseur photovoltaïque (2).

Le convertisseur alimente un circuit d'utilisation (8) et le dispositif est caractérisé en ce qu'il comprend des moyens de contrôle (12, 13 ... 18, 20) connectés entre des bornes de sortie (9, 10) du convertisseur et le circuit d'utilisation (8), pour obtenir la dérivée de la puissance P délivrée par le convertisseur, par rapport à la tension V à ses bornes, et pour minimiser la valeur de cette dérivée.

Application à l'utilisation rationnelle de l'énergie photovoltaïque.

EP 0 027 405 A1

./...

FIG. 2

La présente invention concerne un dispositif de pilotage, à la puissance maximale, d'un convertisseur photovoltaïque. Elle s'applique à l'utilisation rationnelle de l'énergie photovoltaïque.

On sait que l'impédance de sortie d'un convertisseur photovoltaïque dépend de l'éclairement, de la température et de son vieillissement. L'utilisation rationnelle de l'énergie d'un convertisseur photovoltaïque implique donc la nécessité d'interposer un adaptateur d'impédance entre le convertisseur photovoltaïque et un circuit d'utilisation de ce convertisseur. Cet adaptateur permet de maintenir en permanence l'égalité entre l'impédance d'entrée du circuit d'utilisation et l'impédance de sortie du convertisseur, au point de fonctionnement donnant la puissance maximale de celui-ci.

Actuellement, les dispositifs connus ne permettent pas de réaliser de façon satisfaisante une adaptation dynamique d'impédance entre la sortie d'un convertisseur photovoltaïque et l'entrée d'un circuit d'utilisation, de manière à maintenir maximale la puissance délivrée par le convertisseur. Ils utilisent des sondes pour effectuer des mesures thermiques et d'éclairement, nécessaires au pilotage ; ces sondes présentent des inconvénients : elles ne tiennent pas compte d'une évolution des panneaux photovoltaïques au cours du temps : en effet, cette évolution peut être différente de l'évolution des sondes. De plus, ces sondes lient la nature et les performances du dispositif, au circuit d'utilisation. Enfin, elles nécessitent un programme préalable de réglages.

La présente invention a pour but de remédier à cet inconvénient, et notamment de réaliser un dispositif de pilotage d'un convertisseur photovoltaïque, à la puissance maximale, par adaptation dynamique d'impédance entre la sortie d'un convertisseur et l'entrée d'un

B 6747.3 DC

circuit d'utilisation de celui-ci.

Plus précisément, l'invention a pour objet un dispositif de pilotage, à la puissance maximale, d'un convertisseur photovoltaïque alimentant un circuit d'utilisation, caractérisé en ce qu'il comprend des moyens de contrôle, connectés entre des bornes de sortie du convertisseur photovoltaïque et le circuit d'utilisation, pour obtenir la dérivée de la puissance P délivrée par le convertisseur par rapport à la tension V à ses bornes, et pour minimiser la valeur de cette dérivée.

Selon une autre caractéristique de l'invention, le convertisseur étant constitué par au moins deux panneaux identiques, connectés en série par deux bornes de polarités opposées de sorte que le point commun à ces deux bornes soit choisi comme potentiel de référence, deux autres bornes de polarités opposées du convertisseur alimentent le circuit d'utilisation par l'intermédiaire d'un circuit commandant le circuit d'utilisation par une tension V, de sorte qu'un courant I soit fourni au circuit de commande et au circuit d'utilisation, le circuit de contrôle étant constitué par des moyens de correction, pour appliquer au circuit de commande une tension de correction de la tension de commande, cette tension de correction correspondant à la minimisation de la dérivée de la puissance P délivrée par le convertisseur, par rapport à la tension V à ses bornes, cette dérivée étant exprimée sous la forme $\frac{dP}{dV} = I + V . \frac{dI}{dV}$ .

Selon une autre caractéristique, le convertisseur étant constitué par au moins un panneau présentant deux bornes de sortie de polarités opposées, l'une de ces deux bornes étant choisie comme potentiel de référence, ce convertisseur alimente le circuit d'utilisation par l'intermédiaire d'un circuit de commande du circuit d'utilisation par une tension V, de sorte qu'un courant I soit fourni au circuit de commande et au circuit d'utilisation, ce convertisseur alimentant en outre un circuit fournissant aux moyens de contrôle deux tensions opposées par rapport au potentiel de référence, ledit circuit de contrôle étant constitué par des moyens de correction, pour appliquer au circuit de commande une tension de correction de la tension de commande, cette tension de correction correspondant à la minimisation de la dérivée de la puissance P délivrée par le convertisseur, par rapport à la tension V à ses bornes, cette dérivée étant exprimée sous la forme $\frac{dP}{dV} = I + V \cdot \frac{dI}{dV}$ .

Selon une autre caractéristique de l'invention, les moyens de correction comprennent des moyens pour dériver par rapport au temps $\underline{t}$ la tension aux bornes du convertisseur, de manière à former le rapport $\frac{dV}{dt}$, des moyens pour prélever et dériver par rapport au temps, l'intensité I fournie par le convertisseur, de manière à former le rapport $\frac{dI}{dt}$ , des moyens de division dont les entrées sont connectées aux sorties des moyens de dérivation pour obtenir le rapport $\frac{dI}{dV}$, des moyens de multipli-cation de ce rapport par la tension V aux bornes du convertisseur, pour obtenir le produit $V \cdot \frac{dI}{dV}$ , des moyens d'addition de ce produit avec l'intensité I fournie par le convertisseur, de manière à obtenir la somme $I + V \cdot \frac{dI}{dV}$ représentative de la dérivée de la puissance fournie par le convertisseur par rapport à la tension à ses bornes, des moyens pour comparer la valeur de cette dérivée par rapport au potentiel de référence, de manière à obtenir une tension de correction de la tension de commande, la sortie de ces moyens de comparaison étant reliée à une entrée de correction de la tension fournie par le circuit de commande.

Selon une autre caractéristique, le dispositif comprend en outre des moyens de régulation de la tension de correction, connectés entre les moyens de comparaison

.B 6747.3 DC

et le circuit de commande.

Selon une autre caractéristique avantageuse, les divers moyens du dispositif sont des circuits intégrés sur substrat semi-conducteur.

Selon une autre caractéristique avantageuse, les divers moyens du circuit sont alimentés par le convertisseur.

Selon une caractéristique particulière, un convertisseur tension-fréquence est connecté entre le circuit d'utilisation et le circuit de commande.

Selon une autre caractéristique particulière, un régulateur de courant est connecté entre le circuit d'utilisation et le circuit de commande.

D'autres caractéristiques et avantages de l'invention ressortiront mieux de la description qui va suivre, donnée en référence aux dessins annexés , dans lesquels :

- la fig. 1 est un diagramme représentant les variations de la puissance fournie par un convertisseur, en fonction de la tension à ses bornes, pour différents niveaux d'éclairement, de température et de vieillissement de ce convertisseur;

- la fig. 2 représente schématiquement un premier mode de réalisation d'un dispositif de pilotage, à la puissance maximale, d'un convertisseur conforme à l'invention;

- la fig. 3 représente schématiquement un autre mode de réalisation d'un dispositif de pilotage, conforme à l'invention.

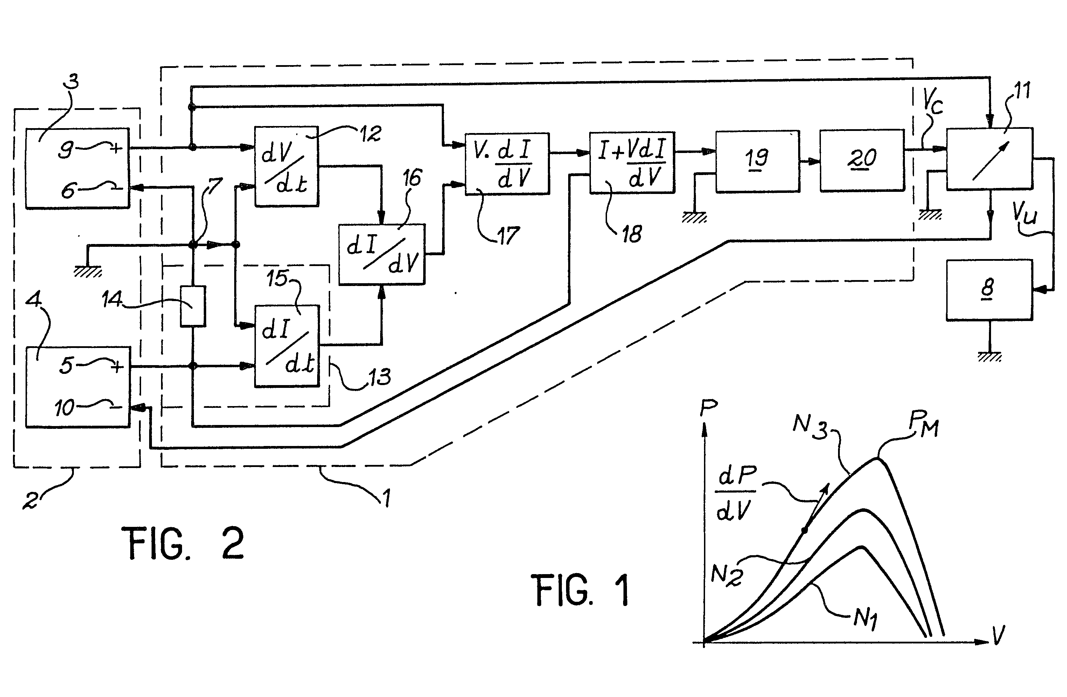

La fig. 1 est un diagramme représentant les variations de la puissance fournie par un convertisseur photovoltaïque, en fonction de la tension à ses bornes, et pour différents niveaux d'éclairement, de température ou de vieillissement, $N_1$, $N_2$, $N_3$... A éclairement cons- tant, la puissance maximale $P_M$ fournie par le convertis-

B 6747.3 DC

seur est obtenue lorsque la dérivée $\frac{dP}{dV}$ de cette puissance par rapport à la tension est nulle. Si I désigne l'intensité du courant circulant dans le circuit d'utilisation connecté aux bornes d'un convertisseur, et si l'on exprime la puissance par la relation P = I.V, la dérivée $\frac{dP}{dV} = I + V \cdot \frac{dI}{dV}$, ce qui peut encore s'écrire :

$$\frac{dP}{dV} = I + V \cdot \frac{dI}{dt} \cdot \frac{dt}{dV} .$$

Le dispositif de contrôle conforme à l'invention est constitué de manière à minimiser cette dernière relation, lorsque le convertisseur alimente un circuit d'utilisation, par l'intermédiaire d'un circuit de commande en tension.

En référence à la fig. 2, on a représenté un dispositif de contrôle 1 d'un convertisseur photovoltaïque 2 à deux panneaux identiques 3, 4, connectés en série par deux bornes de polarités opposées 5, 6. Le point commun 7 de ces deux bornes est choisi comme potentiel de référence. Le convertisseur 2 alimente un circuit d'utilisation 8 par deux autres bornes de polarités opposées 9, 10 des panneaux, par l'intermédiaire d'un circuit 11 de commande en tension ; un courant I est fourni au circuit de commande et au circuit d'utilisation, par le convertisseur. Le circuit de contrôle comprend essentiellement des moyens pour appliquer au circuit de commande 11 une tension de correction $V_c$ de la tension de commande $V_u$. Cette tension de correction, comme on le verra par la suite, correspond à la minimisation de la dérivée de la puissance P délivrée par le convertisseur par rapport à la tension V à ses bornes, cette dérivée étant exprimée sous la forme :

$$\frac{dP}{dV} = I + V \cdot \frac{dI}{dV} .$$

Les moyens de correction du circuit de contrôle 1 comprennent des moyens 12, pour dériver par rapport au temps t la tension V aux bornes du convertisseur, de manière à former le rapport $\frac{dV}{dt}$. Ces moyens de correction comprennent également des moyens 13 pour prélever et dériver par rapport au temps t, l'intensité I fournie par le convertisseur, de manière à former le rapport $\frac{dI}{dt}$. Ces moyens 13 sont essentiellement constitués par un shunt 14, connecté entre la masse de 7 et la borne positive de l'un des panneaux et par un circuit dérivateur 15. Des moyens de division 16 dont les entrées sont connectées aux sorties des moyens de dérivation 12, 13, permettent d'obtenir le rapport $\frac{dI}{dV}$ ; la sortie de ce circuit diviseur 16 est reliée à une entrée de moyens de multiplication 17, dont une autre entrée prélève sur l'une des bornes du convertisseur, la tension V délivrée par celui-ci. Ces moyens de multiplication 17 permettent de former le produit $V \cdot \frac{dI}{dV}$. Des moyens d'addition 18 permettent d'additionner ce produit avec l'intensité I fournie par le convertisseur au circuit d'utilisation et prélevée grâce au shunt 14. La somme $I + V \cdot \frac{dI}{dV}$ est représentative de la dérivée de la puissance fournie par le convertisseur, par rapport à la tension à ses bornes. Des moyens 19 permettent de comparer la valeur de cette dérivée par rapport au potentiel de référence, de manière à obtenir une tension de correction $V_c$ de la tension de commande $V_u$ du circuit d'utilisation. La sortie de ces moyens de comparaison 19 est reliée à une entrée de commande du circuit de commande 11, par l'intermédiaire de moyens de régulation 20 de la tension de correction fournie par les moyens de comparaison 19. Ainsi, la tension de commande $V_u$ du circuit d'utilisation 8, est constamment modulée grâce au circuit de commande, par la tension de correction $V_c$. Il en résulte que le convertisseur photovoltaïque fonctionne constamment à sa puissance maximale $P_M$.

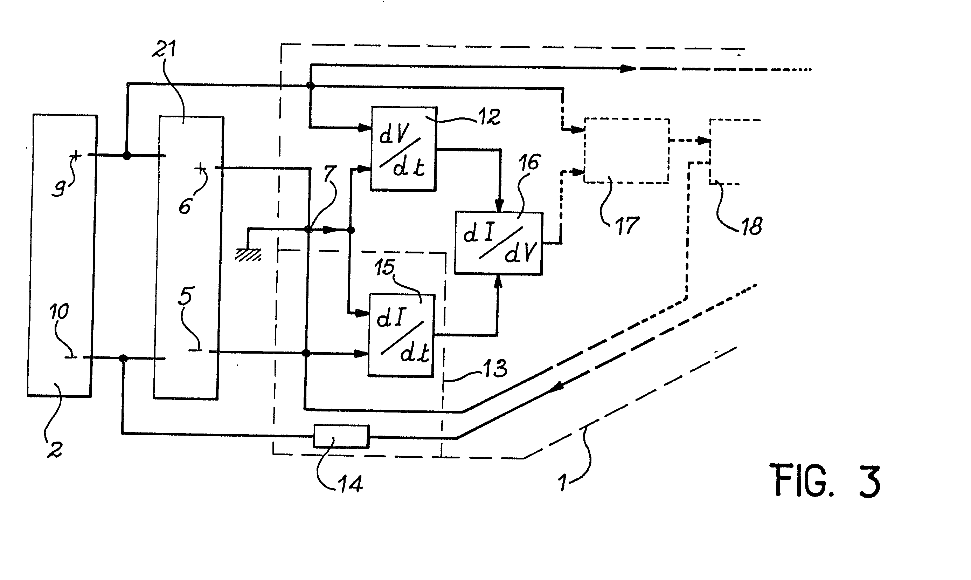

La fig. 3 représente un autre mode de réalisation du dispositif conforme à l'invention. Les éléments correspondants sur cette figure et sur la fig. 2 portent

B 6747.3 DC

les mêmes références. Le fonctionnement du dispositif représenté sur cette figure est semblable à celui du dispositif représenté sur la fig. 2. Le convertisseur photovoltaïque 2 à deux panneaux identiques, est remplacé par un convertisseur à un seul panneau. Ce convertisseur alimente le circuit de commande 11, tandis que sont appliquées au circuit de contrôle d'une part la tension aux bornes du convertisseur, et d'autre part deux tensions opposées par rapport à un potentiel de référence, fournies par les sorties 5, 6 d'un circuit 21, tel qu'un convertisseur de courant continu par exemple. Ce convertisseur est lui-même alimenté par le convertisseur photovoltaïque à un seul panneau. Les divers moyens que comprend le circuit de contrôle sont des circuits intégrés sur substrat semi-conducteur, connus dans l'état de la technique et utilisant principalement des montages à amplificateurs opérationnels. Ces divers moyens sont alimentés par des connexions non représentées, à partir du convertisseur photovoltaïque. Les moyens 20 de régulation de tension, connectés entre les moyens de comparaison 19 et le circuit de commande 11 permettent de réguler la tension de correction en fonction des caractéristiques d'amortissement du circuit d'utilisation, pour éviter les oscillations parasites.

On a supposé, dans les deux modes de réalisation décrits, que le circuit de commande 11 commandait directement en tension le circuit d'utilisation 8. Dans certains circuits d'utilisation, cette commande peut être une commande en fréquence ou en courant, on interpose alors un convertisseur tension-fréquence ou un régulateur de courant (non représenté ) entre la sortie du circuit de commande et l'entrée du circuit d'utilisation.

B 6747.3 DC

REVENDICATIONS

1. Dispositif de pilotage, à la puissance maximale, d'un convertisseur photovoltaïque alimentant un circuit d'utilisation, caractérisé en ce qu'il comprend des moyens de contrôle, connectés entre des bornes de sortie du convertisseur photovoltaïque et le circuit d'utilisation, pour obtenir la dérivée de la puissance P délivrée par le convertisseur par rapport à la tension V à ses bornes, et pour minimiser la valeur de cette dérivée.

2. Dispositif selon la revendication 1, caractérisé en ce que le convertisseur étant constitué par au moins deux panneaux identiques connectés en série par deux bornes de polarités opposées de sorte que le point commun à ces deux bornes soit choisi comme potentiel de référence, deux autres bornes de polarités opposées du convertisseur alimentent le circuit d'utilisation par l'intermédiaire d'un circuit commandant le circuit d'utilisation par une tension V, de sorte qu'un courant I soit fourni au circuit de commande et au circuit d'utilisation, le circuit de contrôle étant constitué par des moyens de correction, pour appliquer au circuit de commande une tension de correction de la tension de commande, cette tension de correction correspondant à la minimisation de la dérivée de la puissance P délivrée par le convertisseur, par rapport à la tension V à ses bornes, cette dérivée étant exprimée sous la forme

$$\frac{dP}{dV} = I + V \cdot \frac{dI}{dV} \cdot$$

3. Dispositif selon la revendication 1, caractérisé en ce que le convertisseur étant constitué par au moins un panneau présentant deux bornes de sortie de polarités opposées, l'une de ces deux bornes étant choisie comme potentiel de référence, ce convertisseur alimente le circuit d'utilisation par l'intermédiaire d'un circuit de commande du circuit d'utilisation par

B 6747.3 DC

une tension V, de sorte qu'un courant I soit fourni au circuit de commande et au circuit d'utilisation, ce convertisseur alimentant en outre un circuit fournissant aux moyens de contrôle deux tensions opposées par rapport à un potentiel de référence, ledit circuit de contrôle étant constitué par des moyens de correction, pour appliquer au circuit de commande une tension de correction de la tension de commande, cette tension de correction correspondant à la minimisation de la dérivée de la puissance P délivrée par le convertisseur, par rapport à la tension V à ses bornes, cette dérivée étant exprimée sous la forme $\frac{dP}{dV} = I + V \cdot \frac{dI}{dV}$ .

4. Dispositif de contrôle selon l'une quelconque des revendications 1 à 3, caractérisé en ce que les moyens de correction comprennent des moyens pour dériver par rapport au temps $t$ la tension aux bornes du convertisseur, de manière à former le rapport $\frac{dV}{dt}$, des moyens pour prélever et dériver par rapport au temps, l'intensité I fournie par le convertisseur, de manière à former le rapport $\frac{dI}{dt}$, des moyens de division dont les entrées sont connectées aux sorties des moyens de dérivation pour obtenir le rapport $\frac{dI}{dV}$, des moyens de multiplication de ce rapport par la tension V aux bornes du convertisseur, pour obtenir le produit $V. \frac{dI}{dV}$, des moyens d'addition de ce produit avec l'intensité I fournie par le convertisseur, de manière à obtenir la somme $I + V \cdot \frac{dI}{dV}$ représentative de la dérivée de la puissance fournie par le convertisseur par rapport à la tension à ses bornes, des moyens pour comparer la valeur de cette dérivée par rapport au potentiel de référence, de manière à obtenir une tension de correction de la tension de commande, la sortie de ces moyens de comparaison étant reliée à une entrée de correction de la tension fournie par le circuit de commande.

5. Dispositif selon la revendication 4, caractérisé en ce qu'il comprend en outre des moyens de

B 6747.3 DC

régulation de la tension de correction, connectés entre les moyens de comparaison et le circuit de commande.

6. Dispositif de contrôle, selon la revendication 4, caractérisé en ce que les divers moyens qu'il comprend sont des circuits intégrés sur substrat semi-conducteur.

7. Dispositif selon la revendication 4, caractérisé en ce que les divers moyens qu'il comprend sont alimentés par le convertisseur.

8. Dispositif selon la revendication 4, caractérisé en ce qu'un convertisseur tension-fréquence est connecté entre le circuit d'utilisation et le circuit de commande.

9. Dispositif selon la revendication 4, caractérisé en ce qu'un régulateur de courant est connecté entre le circuit d'utilisation et le circuit de commande.

B 6747.3 DC

FIG. 2

FIG. 1

0027405

FIG. 3

Office européen
des brevets

**RAPPORT DE RECHERCHE EUROPEENNE**

Numéro de la demande

EP 80 40 1407

| DOCUMENTS CONSIDERES COMME PERTINENTS | | | CLASSEMENT DE LA DEMANDE (Int. Cl. 3) |
|---|---|---|---|
| Catégorie | Citation du document avec indication, en cas de besoin, des parties pertinentes | Revendica-tion concernee | G 05 F 1/66 |
| A | THE CONFERENCE RECORD OF THE TWELFTH IEEE PHOTOVOLTAIC SPECIALISTS CONFERENCE - 1976, 15-18 novembre 1976, BATON ROUGE, LOUISIANA (US) N.F. SHEPARD et al.: "The conceptual design and analysis of a photovoltaic powered experimental residence", pages 705-714. <br><br> * pages 710,711, paragraphe: "Power system implementation" et figures 7 et 8 * <br> --- | 1 <br><br><br><br><br> ı | |
| A | FR - A - 1 460 787 (HONEYWELL) <br><br> * page 1, colonne de gauche, ligne 1 à page 5, colonne de droite, ligne 20; figures 1-5 * <br> & DE - A - 1 513 195 <br> --- | 1 | **DOMAINES TECHNIQUES RECHERCHES (Int. Cl. 3)** <br><br> H 01 L 25/04 <br> 31/02 <br> G 05 F 1/46 <br> 1/64 <br> 1/66 <br> H 02 M 3/00 <br> H 02 J 7/34 |
| A | ENERGY CONVERSION, vol. 17, no. 4, 1977, OXFORD (GB) D.M. DIVAN: "Maximisation of operating efficiency of solar cells" pages 183-187. <br><br> * pages 183-186 * <br><br><br> --------- | 1 | |

CATEGORIE DES DOCUMENTS CITES

X: particulièrement pertinent
A: arriere-plan technologique
O: divulgation non-ecrite
P: document intercalaire
T: theorie ou principe a la base de l'invention
E: demande faisant interference
D: document cite dans la demande
L: document cite pour d'autres raisons

&: membre de la même famille, document correspondant

Le present rapport de recherche a ete etabli pour toutes les revendications

| Lieu de la recherche | Date d achevement de la recherche | Examinateur |
|---|---|---|
| La Haye | 12.01.1981 | ZAEGEL |

OEB Form 1503.1  06.78